Europäisches Patentamt

(19) European Patent Office

Office européen des brevets

(11) Veröffentlichungsnummer: **0 040 646**
**B1**

(12) # EUROPÄISCHE PATENTSCHRIFT

(45) Veröffentlichungstag der Patentschrift:
14.03.84

(51) Int. Cl.³: **B 01 J 3/03,** C 30 B 31/10,
C 30 B 25/08, F 16 L 53/00

(21) Anmeldenummer: **80107641.5**

(22) Anmeldetag: **04.12.80**

(54) Dichter, gekühlter Verschluss für Prozessrohre, insbesondere in der Halbleiterfertigung.

(30) Priorität: 28.05.80 DE 3020264

(43) Veröffentlichungstag der Anmeldung:
02.12.81 Patentblatt 81/48

(45) Bekanntmachung des Hinweises auf die Patenterteilung:
14.03.84 Patentblatt 84/11

(84) Benannte Vertragsstaaten:
FR GB NL

(56) Entgegenhaltungen:
DE - A - 1 442 903
DE - A - 1 475 604
DE - A - 1 918 810
DE - A - 2 537 924
DE - A - 2 730 212
FR - A - 1 549 288
FR - A - 2 143 043
US - A - 3 143 240
US - A - 4 017 102

(73) Patentinhaber: SIEMENS AKTIENGESELLSCHAFT,
Berlin und München Wittelsbacherplatz 2,
D-8000 München 2 (DE)

(72) Erfinder: Schiller, Peter, Dipl.-Ing., Bahnhofstrasse 23,
D-8171 Gaissach (DE)

Dichter, gekühlter Verschluß für Prozeßrohre, insbesondere in der Halbleiterfertigung

Die Erfindung betrifft einen dichten, gekühlten Verschluß für Prozeßrohre, insbesondere in der Halbleiterfertigung.

Unter Prozeßrohren sollen Rohre verstanden werden, in denen z. B. ein Oxidationsprozeß abläuft, ein Diffusionsprozeß durchgeführt wird oder ein Abscheidungsprozeß vor sich geht. Auch Tempervorgänge werden in solchen Rohren vorgenommen. Diese Prozeßrohre sind in der Regel aus Quarz und bei Bedarf mit einem Deckel verschlossen.

Das Quarzrohr eines bekannten Hochdruckoxidationsofens ist mit einem Rohrverschluß aus Stahl versehen. Der Rohrverschluß dient dazu, das Quarzrohr möglichst dicht zu verschließen, um unter anderem zu verhindern, daß Verunreinigungen aus der Umgebung, die unter höherem Druck steht, ins Rohrinnere eindringen. Als Dichtung dienen z. B. zwei Viton O-Ringe. Bei höheren Temperaturen haben aber derartige Dichtungsringe nur sehr begrenzte Lebensdauer. Es ist daher notwendig, sie zu kühlen. Wenn mit Wasser gekühlt wird, und der Rohrverschluß aus Stahl — einem guten Wärmeleiter — besteht, läßt sich nicht verhindern, daß die Kühlung nicht nur auf die unmittelbare Nähe der Dichtungsringe begrenzt bleibt. Das hat zur Folge, daß ein großer Teil der Rohrverschlußoberfläche kälter als der Taupunkt des Dampfes ist. Bei Feucht-Oxidation kondensiert der vorhandene Dampf an diesen kalten Stellen. Es kommt zur Bildung von Tropfen, die zurück ins Quarzrohr laufen. Sie können bis in die Arbeitszonen dringen und hier z. B. die Oxidation wesentlich stören. Zum Verdampfen benötigen sie Wärme, die der Umgebung entzogen wird. Das führt dazu, daß das Temperaturprofil und somit auch das Oxidwachstum ungleichmäßig wird.

Die Innenseite eines derartigen Rohrverschlusses aus Stahl wird stark von Prozeßgasen angegriffen. Es bildet sich sehr schnell eine starke Eisenoxidschicht, die regelmäßig beseitigt werden muß.

Es läßt sich auch nicht vermeiden, daß die sich am Rohrverschluß bildenden Wassertropfen ein Teil des Eisenoxids aufnehmen, es in das Rohr transportieren und hier zur Verschmutzung führen.

Der Erfindung liegt die Aufgabe zugrunde, mit möglichst einfachen Mitteln einen hermetisch dichten, gekühlten Verschluß für Prozeßrohre in der Hochdruckanwendung, insbesondere in der Halbleiterfertigung zu schaffen, der ein neutrales Verhalten gegenüber Prozeßgasen aufweist. Diese Aufgabe wird dadurch gelöst, daß ein Rohrverschluß aus Material mit niedriger Wärmeleitfähigkeit und hoher chemischer Beständigkeit, z. B. aus Quarz, Verwendung findet. Mit einem derartigen Rohrverschluß werden die geschilderten Nachteile beseitigt. Sein Verhalten in Prozeßgasen ist neutral und seine Wärmeleitfähigkeit um den Faktor 10 niedriger als die des Stahls. Aufgrund dieser kleinen Wärmeleitfähigkeit wird die Kondensation zum größten Teil unterdrückt, da die Oberfläche des Rohrverschlusses eine über dem Taupunkt liegende Temperatur behält.

Bei den bisher bekannten Prozeßrohren erfolgt die Kühlung z. B. über einen vorgesetzten Metallkragen, der ständig mit dem Rohr verbunden ist und einen Teil des Prozeßraumes darstellt. Nach einer Weiterbildung der Erfindung soll auch hierbei das Metallteil wegfallen, weil Korrosion und Kondensation dadurch entstehen können. Dies geschieht in der Weise, daß das Kühlmittel, z. B. Wasser, direkt um den Flansch des Prozeßrohres geführt wird. Bei einer derartigen Ausgestaltung fällt der Metallkragen weg.

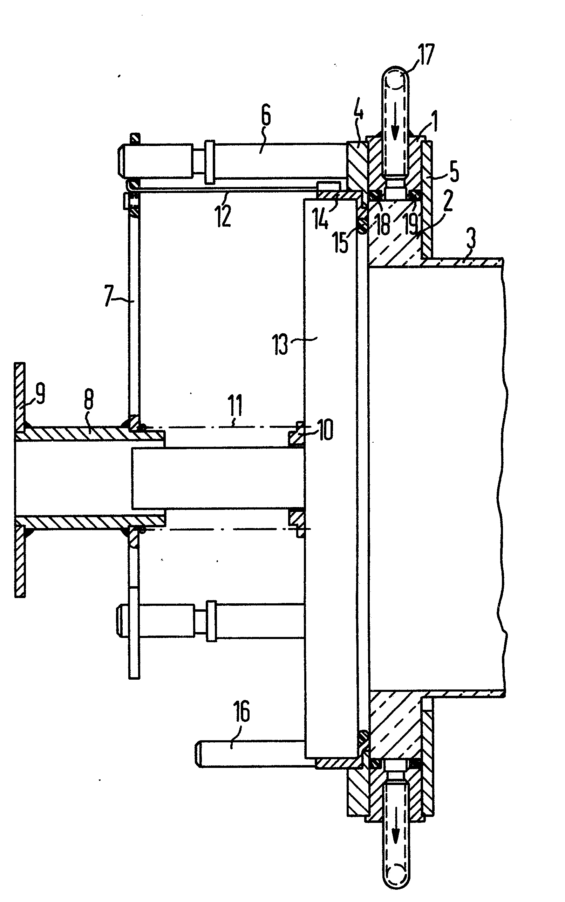

Die Erfindung wird an einem in der Figur dargestellten Ausführungsbeispiel erläutert.

In der Figur ist mit 1 ein Kühlkörper in Form eines Ringes dargestellt, der direkt auf dem Flansch 2 des Prozeßrohres 3 aufliegt. Durch Platten 4 und 5 wird der Kühlkörper am Flansch des Rohres festgehalten. Mit den Bezugszeichen 6 bis 12 sind Arretiervorrichtungen für den Rohrverschluß 13 bezeichnet. Das Bezugszeichen 14 kennzeichnet einen Dichtungsringhalter und 15 den zugehörigen Dichtungsring. Am unteren Rand der Figur ist eine Auflagevorrichtung 16 angedeutet.

Auf dem Kühlkörper 1 ist die Kühlmittelzuleitung 17 angeordnet. Der Zufluß des Kühlmittels erfolgt in Pfeilrichtung. Der Kühlkörper ist mit zwei Dichtungsringen 18, 19 gegenüber dem Flansch des Prozeßrohres abgedichtet.

**Patentansprüche**

1. Hermetisch dichter, gekühlter Verschluß für Prozeßrohre in der Hochdruckanwendung, insbesondere in der Halbleiterfertigung, dadurch gekennzeichnet, daß ein Rohrverschluß (13) aus Material mit niedriger Wärmeleitfähigkeit und hoher chemischer Beständigkeit, z. B. Quarz, Verwendung findet.

2. Rohrverschluß nach Anspruch 1, dadurch gekennzeichnet, daß das Kühlmittel, z. B. Wasser, direkt um den Flansch (2) des Prozeßrohres (3) geführt wird.

**Claims**

1. A hermetically sealed, cooled closure for process pipes in high pressure applications, in particular in semiconductor production, characterised in that a pipe closure (13) is used which consists of material having a low heat conductivity and a high chemical resistance, e. g. quartz.

2. A pipe closure as claimed in Claim 1, characterised in that the coolant, e. g. water, is conducted directly around the flange (2) of the process pipe (3).

## Revendications

1. Fermeture refroidie, hermétiquement étanche, pour des tubes de traitement utilisés sous des pressions élevées, notamment dans la fabrication des semiconducteurs, caractérisée par le fait qu'on utilise une fermeture (13) de tube en un matériau possédant une conductibilité thermique faible et une résistance chimique élevée, par exemple du quartz.

2. Fermeture de tube suivant la revendication 1, caractérisée par le fait que le fluide de refroidissement, par exemple de l'eau, est guidé directement autour de la collerette (2) du tube de traitement (3).